# EUROPÄISCHE PATENTSCHRIFT

(11) **EP 1 112 621 B1**
(45) Veröffentlichungstag und Bekanntmachung des Hinweises auf die Patenterteilung: **06.03.2002**
(21) Anmeldenummer: 99944368.2
(22) Anmeldetag: 12.08.1999
(51) Int. Cl.: H03M 7/40

(54) **VORRICHTUNG UND VERFAHREN ZUM ENTROPIE-CODIEREN VON INFORMATIONSWÖRTERN UND VORRICHTUNG UND VERFAHREN ZUM DECODIEREN VON ENTROPIE-CODIERTEN INFORMATIONSWÖRTERN**
DEVICE AND METHOD FOR ENTROPY ENCODING OF INFORMATION WORDS AND DEVICE AND METHOD FOR DECODING ENTROPY-ENCODED INFORMATION WORDS
DISPOSITIF ET PROCEDE POUR EFFECTUER UN CODAGE ENTROPIQUE DE MOTS D'INFORMATION ET DISPOSITIF ET PROCEDE POUR DECODER DES MOTS D'INFORMATION AYANT SUBI UN CODAGE ENTROPIQUE

(30) Priorität: 07.09.1998 DE 19840835
(43) Veröffentlichungstag der Anmeldung: 04.07.2001
(73) Patentinhaber: Fraunhofer-Gesellschaft zur Förderung der angewandten Forschung e.V., 80636 München (DE)
(72) Erfinder: DIETZ, Martin, D-90429 Nürnberg (DE); NOWBAKHT-IRANI, Ali, 5611 WE Eindhoven (NL); SPERSCHNEIDER, Ralph, D-91056 Erlangen (DE); KUNZ, Oliver, D-96145 Sesslach (DE)
(74) Vertreter: Schoppe, Fritz, Dipl.-Ing.
(86) Internationale Anmeldenummer: EP9905859
(87) Internationale Veröffentlichungsnummer: WO0014886

(56) Entgegenhaltungen:
- EP-A- 0 732 855
- FRAENKEL A S ET AL: "Bidirectional Huffman coding" COMPUTER JOURNAL,GB,OXFORD UNIVERSITY PRESS, SURREY, Bd. 33, Nr. 4, Seite 296-307 XP002080409 ISSN: 0010-4620

## Beschreibung

Die vorliegende Erfindung bezieht sich auf ein Konzept zum Entropiecodieren und auf ein entsprechendes Konzept zum Decodieren von Entropie-codieren Informationswörtern. Insbesondere bezieht sich die vorliegende Erfindung auf die fehlersichere Entropie-Codierung und entsprechende Decodierung von Audiosignalen.

Moderne Audiocodierverfahren bzw. -decodierverfahren, die beispielsweise nach dem Standard MPEG-Layer 3 arbeiten, sind in der Lage, die Datenrate von Audiosignalen beispielsweise um einen Faktor 12 zu komprimieren, ohne die Qualität derselben merkbar zu verschlechtern. Um eine derartig hohe Datenratenreduktion zu erreichen, wird ein Audiosignal abgetastet, wodurch eine Folge von zeitdiskreten Abtastwerten erhalten wird. Wie es in der Technik bekannt ist, wird diese Folge von zeitdiskreten Abtastwerten mittels geeigneter Fensterfunktionen gefenstert, um gefensterte Blöcke von zeitlichen Abtastwerten zu erhalten. Ein Block zeitlich gefensterter Abtastwerte wird dann mittels einer Filterbank, einer modifizierten diskreten Cosinustransformation (MDCT) oder einer anderen geeigneten Einrichtung in den Frequenzbereich transformiert, um Spektralwerte zu erhalten, die insgesamt das Audiosignal, d. h. den zeitlichen Ausschnitt, der durch den Block von zeitdiskreten Abtastwerten gegeben ist, im Frequenzbereich darstellen. Üblicherweise werden sich zu 50% überlappende zeitliche Blöcke erzeugt und mittels einer MDCT in den Frequenzbereich transformiert, wodurch aufgrund der speziellen Eigenschaften der MDCT immer beispielsweise 1024 zeitdiskrete Abtastwerte zu 1024 Spektralwerten führen.

Es ist bekannt, daß die Aufnahmefähigkeit des menschlichen Ohrs vom Augenblicksspektrum des Audiosignals selbst abhängt. Diese Abhängigkeit ist in dem sog. psychoakustischen Modell erfaßt, mittels dem es seit längerem möglich ist, abhängig vom augenblicklichen Spektrum Maskierungsschwellen zu berechnen. Maskierung bedeutet, daß ein bestimmter Ton bzw. Spektralanteil verdeckt wird, wenn beispielsweise ein benachbarter Spektralbereich eine relativ hohe Energie besitzt. Diese Tatsache der Maskierung wird ausgenutzt, um die nach der Transformation vorhandenen Spektralwerte möglichst grob zu quantisieren. Es wird daher angestrebt, einerseits hörbare Störungen im wieder decodierten Audiosignal zu vermeiden und andererseits möglichst wenig Bits zu verwenden, um das Audiosignal zu codieren bzw. hier zu quantisieren. Die durch die Quantisierung eingeführten Störungen, d. h. das Quantisierungsrauschen, soll unter der Maskierungsschwelle liegen und somit unhörbar sein. Gemäß bekannter Verfahren wird daher eine Einteilung der Spektralwerte in sog. Skalenfaktorbänder durchgeführt, die den Frequenzgruppen des menschlichen Ohrs entsprechen sollten. Spektralwerte in einer Skalenfaktorgruppe werden mit einem Skalenfaktor multipliziert, um Spektralwerte eines Skalenfaktorbandes insgesamt zu skalieren. Die durch den Skalenfaktor skalierten Skalenfaktorbänder werden anschließend quantisiert, woraufhin quantisierte Spektralwerte entstehen. Selbstverständlich ist eine Gruppierung in Skalenfaktorbänder nicht entscheidend. Sie wird jedoch bei den Standards MPEG-Layer 3 bzw. bei dem Standard MPEG-2 AAC (AAC = Advanced Audio Coding) verwendet.

Ein sehr wesentlicher Aspekt der Datenreduzierung besteht in der nach dem Quantisieren folgenden Entropie-Codierung der quantisierten Spektralwerte. Für die Entropiecodierung wird üblicherweise eine Huffman-Codierung verwendet. Unter einer Huffman-Codierung versteht man eine Codierung mit variabler Länge, d. h. die Länge des Codeworts für einen zu codierenden Wert ist abhängig von dessen Auftrittswahrscheinlichkeit. Logischerweise ordnet man dem wahrscheinlichsten Zeichen den kürzesten Code, d. h. das kürzeste Codewort, zu, so daß mit der Huffman-Codierung eine sehr gute Redundanzreduktion erreicht werden kann. Ein Beispiel für eine allseits bekannte Codierung mit allgemeiner Länge ist das Morse-Alphabet.

In der Audiocodierung werden Huffman-Codes zur Codierung der quantisierten Spektralwerte benutzt. Ein moderner Audio-Coder, der beispielsweise nach dem Standard MPEG-2 AAC arbeitet, verwendet zur Codierung der quantisierten Spektralwerte verschiedene Huffman-Codetabellen, die dem Spektrum nach bestimmten Kriterien abschnittsweise zugeordnet werden. Dabei werden immer 2 oder 4 Spektralwerte in einem Codewort gemeinsam codiert.

Ein Unterschied des Verfahrens nach MPEG-2 AAC gegenüber dem Verfahren MPEG-Layer 3 besteht nun darin, daß verschiedene Skalenfaktorbänder, d. h. verschiedene Spektralwerte, zu beliebig vielen Spektralabschnitten oder "Sections" gruppiert werden. Bei AAC umfaßt ein Spektralabschnitt oder eine "Section" zumindest vier Spektralwerte aber vorzugsweise mehr als vier Spektralwerte. Der gesamte Frequenzbereich der Spektralwerte wird daher in benachbarte Sections aufgeteilt, wobei eine Section ein Frequenzband darstellt, derart, daß alle Sections zusammen den gesamten Frequenzbereich, der durch die Spektralwerte nach der Transformation derselben überdeckt wird, umfassen.

Einem Abschnitt wird nun ebenso wie beim MPEG-Layer-3-Verfahren zum Erreichen einer maximalen Redundanzreduktion eine sog. Huffman Tabelle aus einer Mehrzahl derartiger Tabellen zugeordnet. Im Bitstrom des AAC-Verfahrens, welches üblicherweise 1024 Spektralwerte aufweist, befinden sich nun die Huffman-Codewörter für die Spektralwerte in aufsteigender Frequenzreihenfolge. Die Information über die in jedem Frequenzabschnitt verwendete Tabelle wird in den Seiteninformationen übertragen.

Neben den Spektralwerten werden beim Standard MPEG-2-AAC (ISO/IEC JTC1/SC29/WG11 IS 13818.7) die Skalenfaktoren einer Huffman-Codierung unterzogen, um die zu übertragende Bitmenge weiter zu reduzieren. Zur weiteren Erhöhung der Effizienz werden die Skalenfaktoren innerhalb eines Frames, d. h. innerhalb eines zugehörigen gefensterten und in den Frequenzbereich transformierten Blocks von Abtastwerten, Differenz-codiert. Dabei wird ausgehend von einem Startwert, typischerweise dem ersten Skalenfaktor eines frames, der absolut gegeben ist, die Differenz ermittelt. Dies ist besonders effizient für die Kompression, da kleine Änderungen von einem Skalenfaktor zum nächsten sehr wahrscheinlich sind.

Nachteilig an dem verwendeten Huffman-Code ist die Tatsache, daß er praktisch keine Redundanz besitzt. Obwohl dies aus Biteinsparungs- bzw. Datenkompressionsgründen absolut wünschenswert ist, führt es doch dazu, daß eben keine Redundanz verfügbar ist, um eine Fehlerrobustheit erhalten zu können.

Wenn ein Huffman-codiertes Signal über einen fehlerbehafteten Kanal übertragen wird, besteht im Decodierer nahezu keine Möglichkeit, noch eventuell gültige Werte nach Auftreten des Fehlers zu "retten". Dies sei anhand der Huffman-codierten Skalenfaktoren kurz erläutert. Wie es bereits erwähnt wurde, ist der Huffman-Code ein Code mit variabler Länge. Dies ist gerade das Wesen des Huffman-Codes, derart, daß sehr häufig auftretende Werte sehr kurze Code-Wörter zugeordnet bekommen, während seltener auftretende Werte eher längere bzw. sehr lange Code-Wörter erhalten. In der Bitstrom-Syntax des angesprochenen Audiocodierers werden die Huffman-Codewörter nacheinander für einen Frame in den Bitstrom geschrieben. Der Beginn des Code-Worts für einen Skalenfaktor ist nur zu ermitteln, wenn das entsprechende vorausgehende Code-Wort korrekt erkannt, d. h. decodiert, worden ist.

Beispielhaft bedeutet dies, daß zwischen 40 und 100 Skalenfaktoren in einem Frame vorkommen, je nach dem wieviel Skalenfaktorbänder erzeugt worden sind. Dies bedeutet auch, daß etwa 40 bis zu etwa 100 Skalenfaktoren pro Frame Huffman-codiert werden. Die Code-Wörter für die einzelnen Skalenfaktoren werden in aufsteigender Reihenfolge einfach nacheinander in den Bitstrom geschrieben. Führt die Übertragung des Bitstroms über einen fehlerbehafteten Kanal, wie es beispielsweise ein Funkkanal ist, zu einem Bitfehler, der die Länge des Code-Worts verändert, das dem allerersten Skalenfaktor zugeordnet ist, so ist es unmöglich, die Skalenfaktoren des gesamten Frames fehlerfrei zu decodieren, da der Decodierer keine Möglichkeit hat, den Beginn des Code-Worts für den zweiten Skalenfaktor zu ermitteln. Obwohl unter Umständen alle anderen Skalenfaktoren außer dem am Anfang stehenden Skalenfaktor, der beim Beispiel gestört worden ist, korrekt übertragen worden sind, besteht im Codierer daher keine Möglichkeit mehr, die korrekt übertragenen Skalenfaktoren zu decodieren.

Die Fachveröffentlichung "A tool for generating bit error resilient VLC tables" von Göran Bang und von Göran Roth, Proposal für ISO/IEC JTC 1/SC29/WG11 vom Juli 1996 bezieht sich auf ein Konzept zum Codieren und Decodieren von Videoinformationen und Audioinformationen unter Verwendung eines Codes variabler Länge (VLC), das zur Verwendung in Verbindung mit fehleranfälligen Kanälen geeignet ist. Wenn ein Bitfehler in der Vorwärtsrichtung eines empfangenen Bitstroms erfaßt wird, wird in der umgekehrten Richtung decodiert. Wenn ein Bitfehler auch bei der Decodierung in der umgekehrten Richtung erfaßt wird, wird das Decodieren in der umgekehrten Richtung ebenfalls abgebrochen. Der verwendete Code ist ein unsymmetrischer Code mit fester Länge, in den ein symmetrischer Code mit variabler Länge gemischt wird, derart, daß auf eine bestimmte Anzahl von Bits eines Codeworts fester Länge ein Bit eines symmetrischen Codeworts mit variabler Länge folgt. Die symmetrischen Codewörter variabler Länge dienen lediglich der Fehlerrobustheit und tragen keine Nutzinformationen. Auf der Empfängerseite werden zunächst die symmetrischen Codewörter variabler Länge extrahiert und auf übertragungsfehler analysiert.

Nachteilig an diesem gemischten Code ist die Tatsache, daß Fehler nicht festgestellt werden können, die in den Codewörtern fester Länge auftreten, da lediglich die symmetrischen Codewörter variabler Länge untersucht werden. Andererseits können ungestörte Codewörter fester Länge als fehlerbehaftet identifiziert werden, wenn die dazu gehörigen Codewörter variabler Länge gestört sind.

Das U. S. Patent Nr. 5,488,616 befaßt sich mit einem System zum Liefern von umkehrbaren Codes variabler Länge. Hierzu wird aus einem nicht-reversiblen Code variabler Länge, der lediglich provisorisch erzeugt wird, ein asymmetrischer umkehrbarer Code erzeugt. Der nicht-reversible Code variabler Länge wird ferner in einen symmetrischen reversiblen Code umgewandelt. Eine Auswahleinrichtung wählt entweder den asymmetrischen reversiblen Code oder den symmetrischen reversiblen Code als Ausgangssignal. Der symmetrische reversible Code ist durch einen vollständigen Codebaum dargestellt, bei dem sämtliche Zweige entweder durch symmetrische Codewörter oder durch Verzweigungspunkte abgeschlossen sind, wobei diese Verzweigungspunkte wieder durch ein symmetrisches Codewort abgeschlossen sind oder zu weiteren Verzweigungspunkten führen. Der Codebaum enthält ausschließlich symmetrische Codewörter.

Die EP 0 732 855 A2 offenbart ein System zum Codieren und/oder Decodieren von Videobildern unter Verwendung von Codewörtern variabler Länge. Der Codierer umfaßt einen ersten Codierer mit einer Codeworttabelle für Quellensymbole in einem Bereich von Quellensymbolen, wobei diese erste Codetabelle Codewörter · mit variabler Länge, die Quellensymbolen zugeordnet sind, aufweist. Die Quellensymbole, die durch Codewörter variabler Länge der ersten Codetabelle codiert werden können, haben eine relative hohe Auftrittshäufigkeit. Ein Quellensymbol, für das kein Codewort aus der ersten Codetabelle vorhanden ist, wird in einen zweiten Codierer eingegeben, der eine Codetabelle mit Codeworten fester Länge hat, um dem Quellensymbol ein Codewort fester Länge zuzuweisen. Darüber hinaus wird dem Codewort fester Länge ein Escape-Code vorangestellt und nachgestellt, wobei der Escape-Code aus der Codetabelle des ersten Codierers, der Codewörter variabler Länge hat, entstammt. Die Codewörter variabler Länge des ersten Codierers sind umkehrbare Codewörter, wobei die Codewörter des zweiten Codierers eine feste Länge haben. Damit wird ein einziger Datenstrom erzeugt, der aus umkehrbaren Codewörtern variabler Länge und aus Escape-Codes besteht, wobei immer zwischen zwei Escape-Codes ein Codewort fester Länge steht. Dieser Datenstrom kann sowohl in Vorwärts- als auch in Rückwärtsrichtung decodiert werden, wobei ein Decodierer, wenn er auf einen Escape-Code stößt, die Gruppe von Bits, die dem Escape-Code folgen, als Codewort fester Länge erkennt, da der Decodierer für die Anzahl der Bits in der Gruppe, d.h. über die Länge der Codewörter fester Länge, informiert ist.

Die Aufgabe der vorliegenden Erfindung besteht darin, ein Konzept zum Entropie-Codieren von Informationswörtern und zum Decodieren von Entropie-codierten Informationswörtern zu schaffen, das bei einer Übertragung der Entropie-codierten Informationswörter über einen fehlerbehafteten Kanal eine bessere Fehlererkennung ermöglicht und dennoch eine möglichst gute Codiereffizienz liefert.

Diese Aufgabe wird durch eine Vorrichtung zum Entropie-Codieren nach Patentanspruch 1, eine Vorrichtung zum Decodieren nach Patentanspruch 10, ein Verfahren zum Entropie-Codieren nach Patentanspruch 19 sowie durch ein Verfahren zum Decodieren nach Patentanspruch 20 gelöst.

Der vorliegenden Erfindung liegt die Erkenntnis zugrunde, daß nur die Informationswörter effektiv fehlerrobust übertragen werden können, die durch umkehrbare, z. B. symmetrische, Codewörter codiert sind. Nur umkehrbare Codewörter erlauben ein Vorwärts- und Rückwärtsdecodieren einer Sequenz von Codewörtern, die einer Sequenz von Informationswörtern eindeutig zugeordnet ist. Im Gegensatz zum Huffman-Code, der unsymmetrische Codewörter aufweist, der jedoch aus Datenkompressionssicht nabezu optimal ist, besitzt ein symmetrischer Code eine höhere Redundanz. Diese Redundanz kann vorteilhaft zur Fehlererkennung ausgenutzt werden. Um jedoch im Sinne der Fehlersicherung nicht allzuviel Kompressionsgewinn zu opfern, werden gemäß der vorliegenden Erfindung nicht alle Informationswörter mittels symmetrischer Codewörter codiert, sondern lediglich die Informationswörter, die in einem bestimmten Bereich von Informationswörtern liegen. Informationswörter, die außerhalb des Bereichs liegen, werden nicht mittels des symmetrischen Codes codiert, sondern können gemäß einem bevorzugten Ausführungsbeispiel der vorliegenden Erfindung Huffman-codiert werden. Es wird somit ein Kompromiß zwischen Fehlerrobustheit auf der einen Seite und Datenkompression auf der anderen Seite gemacht.

Ein weiterer wichtiger Aspekt für die Größe des Bereichs von Informationswörtern, die durch symmetrische Codewörter codiert werden, ist die Tatsache, daß zur Fehlereingrenzung ein kurzer Code, d. h. eine kleine Codetabelle, wünschenswert ist. Die Größe des Bereichs legt implizit die Länge des längsten Codeworts fest, da mit zunehmender Anzahl von Codewörtern in der Tabelle auch die Länge der gültigen Codewörter zunimmt.

Die Fehlereingrenzung wird erfindungsgemäß dadurch vorgenommen, daß ein Decodierer ungültige, d. h. nicht-umkehrbare, Codewörter erkennt und daraus folgert, daß hier ein Übertragungsfehler vorliegt, da ein solches Codewort per Definition nicht im Codierer erzeugt wurde. Die Wahrscheinlichkeit, daß eine Störung zu einem ungültigen Codewort führt, ist dann am höchsten, wenn nur eine kleine Anzahl von Codewörtern vorhanden ist. Existiert eine sehr große Anzahl von Codewörtern, so wird die Wahrscheinlichkeit immer kleiner, daß eine Störung zu einem ungültigen Codewort führt, da auch die Länge der ungültigen Codewörter immer mehr zunimmt.

Das erfindungsgemäße Verfahren ist besonders dort vorteilhaft, wo die zu codierenden Informationswörter im wesentlichen innerhalb eines Bereichs liegen, und nur mit kleiner Wahrscheinlichkeit Informationswörter außerhalb des Bereichs liegen. Je kleiner der Bereich ist, um so weniger symmetrische Codewörter sind erforderlich, und um so besser ist die Fehlerdetektion, die durch Hinzufügung künstlicher ungültiger Codewörter erhöht werden könnte. Es wird also versucht, den Bereich der Informationswörter, die mittels symmetrischer Codewörter codiert werden, im Sinne einer effektiven Fehlereingrenzung möglichst klein zu wählen, und doch so groß zu wählen, daß die Informationswörter mit großer Wahrscheinlichkeit innerhalb dieses Bereichs liegen und symmetrisch codiert werden, um insgesamt eine ausreichende Fehlerrobustheit zu schaffen.

Eine bevorzugte Anwendung der vorliegenden Erfindung besteht im Entropie-Codieren von Skalenfaktoren eines Transformations-codierten Audiosignals, da bei dieser Anwendung statistisch gesehen 98% der auftretenden Skalenfaktorwerte innerhalb eines überschaubaren Bereichs liegen, der durch symmetrische Codewörter codiert werden kann, die noch keine übermäßige Länge haben. Soll ein Informationswort Entropie-codiert werden, das außerhalb dieses Bereiches liegt, so wird ein zusätzlicher Wert übertragen, der "Escape" genannt wird. Der Escape-Wert wird vorzugsweise Huffman-codiert und separat von den symmetrisch codierten Skalenfaktoren im Audiobitstrom übertragen.

Der erfindungsgemäße Sinn der Escape-Codierung besteht also darin, trotz einer relativ kleinen RVLC-Tabelle mit guten Fehlererkennungseigenschaften einen großen Bereich von Codewörtern abdecken zu können. Die Codiereffizienz leidet in der besagte bevorzugten Anwendung kaum, da Escape-codierte Werte hier nur selten auftreten.

Die Anwendung der vorliegenden Erfindung auf die Skalenfaktoren eines Transformations-codierten Audiosignals ist besonders deshalb vorteilhaft, da bereits kleinere Störungen in den Skalenfaktoren durch einen nicht-idealen Kanal zu stark hörbaren Störungen führen, da bekanntermaßen ein Skalenfaktor mehrere Spektrallinien multiplikativ gewichtet. Da ferner die Skalenfaktoren im Vergleich zu den codierten Spektralwerten nur einen relativ kleinen Teil der Gesamtbitmenge ausmachen, führt ein Schutz der Skalenfaktoren durch einen redundanten Code nicht zu einem wesentlichen Mehraufwand an Bits. Dieser geringe Mehraufwand wird durch die Fehlersicherheit der Skalenfaktoren, die im Vergleich zu ihrer Bitmenge ungleich stärkere Störungen in ein Audiosignal einführen können, mehr als gerechtfertigt.

Die vorliegende Erfindung ist jedoch nicht auf das Entropie-Codieren bzw. Decodieren von Skalenfaktoren begrenzt, sondern ist überall dort vorteilhaft, wo Informationswörter zu codieren sind, die mit hoher Wahrscheinlichkeit in einem Bereich liegen, derart, daß ohne großen Effizienzverlust mit relativ kurzen symmetrischen Codewörtern ausgekommen werden kann, wobei Werte außerhalb des Bereichs durch Escape-Sequenzen codiert werden können.

Bevorzugte Ausführungsbeispiele der vorliegenden Erfindung werden nachfolgend bezugnehmend auf die beiliegenden Zeichnungen erläutert. Es zeigen:
- Fig. 1: ein schematisches Blockschaltbild für einen erfindungsgemäßen Codierer;
- Fig. 2: ein schematisches Blockschaltbild für einen erfindungsgemäßen Decodierer;
- Fig. 3: eine schematische Darstellung des durch den in Fig. 2 gezeigten Decodierer verarbeiteten Stroms aus Codewörtern;
- Fig. 4A: bis 4C symmetrische Codes gemäß dem Stand der Technik; und
- Fig. 5: einen umkehrbaren Code gemäß der vorliegenden Erfindung.

Bevor jedoch detailliert auf die Fig. eingegangen wird, seien einige allgemeine Aspekte der Entropie-Codierung dargestellt. Insbesondere wird auf die Besonderheiten bei der Codierung differentiell codierter Werte eingegangen, die auf vorteilhafte Weise mit dem Codieren mittels symmetrischer Codewörter und Escape-Werte kombiniert werden kann.

Der erfindungsgemäße Code stellt einen Entropie-Code dar, der ähnlich dem vielfach verwendeten Huffman-Code häufig auftretenden Werten kurze Codewörter und selten auftretenden Werten lange Codewörter zuweist. Der erfindungsgemäße Code unterscheidet sich jedoch vom Huffman-Code folgendermaßen:

Zunächst erlaubt die verwendete Codierung im Gegensatz zur Huffman-Codierung eine Decodierung von beiden Seiten (vorwärts und rückwärts). Dies wird in der Technik auch als "Reversible Variable Length Coding" (RVLC) bezeichnet. Die Rückwärtsdecodierung ist dann möglich, wenn umkehrbare, z. B. symmetrische Codewörter, verwendet werden, d. h. wenn ein Codebuch oder eine Codetabelle mit umkehrbaren Codewörtern eingesetzt wird.

Weiterhin erlaubt die Verwendung eines RVL-Codes den Effekt, daß die Codetabelle, d. h. die Menge der zur Verfügung stehenden Codewörter, keinen "vollständigen Baum" bildet. Es gibt also Codesymbolsequenzen, die kein gültiges Codewort ergeben, d. h. die Codewörter ergeben, die nicht symmetrisch sind. Die Lücken, die in dem Baum entstehen, können ausgenutzt werden, um Übertragungsfehler zu detektieren, da sie darauf hinweisen, daß ein empfangenes Codewort niemals durch einen Sender erzeugt worden ist.

Da die Huffman-Codierung informationstheoretisch optimal ist, macht es keinen Sinn, einen anderen Code zu benutzen, wenn das einzige Ziel darin besteht, die Datenkompression zu maximieren. Wenn es jedoch um eine Steigerung des Fehlerunempfindlichkeit bei möglichst geringem Verlust an Kompressionseffizienz geht, ist der Huffman-Code nicht vorteilhaft. Durch die Codierung mit Codewörtern variabler Länge kann sich ein Fehler vom gestörten Codewort auf alle nachfolgenden Codewörter fortpflanzen. Durch einen Bitfehler wird also die Länge eines Codeworts verfälscht, was dazu führt, daß alle nachfolgenden Codewörter in einer Codewortsequenz nicht mehr decodiert werden können, da der Decodierer keine Kenntnis davon besitzt, wo die entsprechenden Codewörter beginnen.

Wird anstatt des Codes mit variabler Länge, z. B. dem Huffman-Code, nun ein umkehrbarer Code mit variabler Länge verwendet, so kann aufgrund des Vorhandenseins ungültiger Codewörter ein Fehler, der die Länge eines Codeworts ändert, in der Regel sehr schnell diagnostiziert werden. Wird ein ungültiges Codewort bekannt, so wird die Decodierung abgebrochen. Dies ist bei einer Huffman-Codierung nicht möglich, da alle Codewörter gültig sind, und daher keine ungültigen Codewörter existieren. Darüberhinaus erlaubt der RVLC eine Decodierung von hinten, wodurch der Fehler besser eingegrenzt werden kann. Es sei an folgendem Beispiel dargelegt. Eine erfindungsgemäße Codetabelle könnte beispielsweise folgendermaßen lauten:

| Informationswort | Codewort |
|---|---|
| 3 | 110011 |
| 2 | 11011 |
| 1 | 111 |
| 0 | 0 |
| -1 | 101 |
| -2 | 1001 |
| -3 | 10001 |

Der Bereich für Informationswörter, die durch diese Codetabelle allein mittels symmetrischer Codewörter codiert werden kann, reicht also von -2 bis +2. Werte, die außerhalb dieser Grenzen liegen, d. h. die betragsmäßig größer als 2 sind, werden zusätzlich zu dem symmetrischen Codewort für -3 bzw. +3 mit einem Escape-Wert versehen.

Codewörter, die in der dargestellten Codetabelle nicht vorkommen können, sind die folgenden:
10000
11000
110010
11010

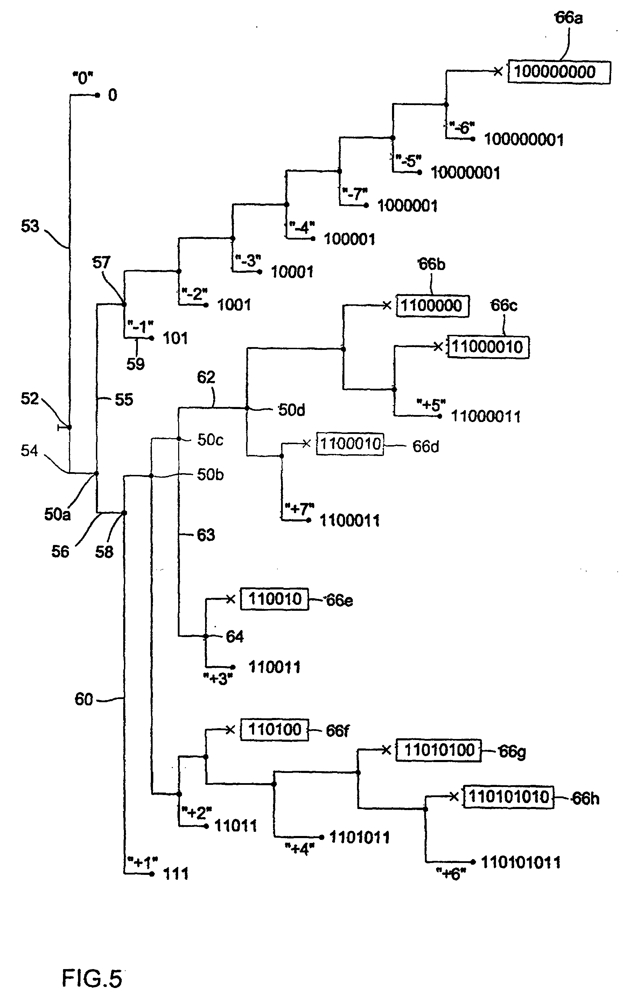

Bezüglich einer detaillierteren Darstellung eines erfindungsgemäßen Codes sei auf Fig. 5 und die entsprechende Erörterung weiter hinten verwiesen.

Es sei im nachfolgenden als fiktives Beispiel eine Zahlenfolge 1, -3, 1, 2, -1 betrachtet, die über einen fehlerbehafteten Kanal übertragen werden soll:

**Tabelle 2**

| | | | | | |
|---|---|---|---|---|---|
| Sequenz von Informationswörtern | 1, | -3, | 1, | 2, | -1 |
| Sequenz von Codewörtern | 111 | 10001 | 111 | 11011 | 101 |

Wenn der Fall betrachtet wird, daß durch einen durch den Kanal erzeugten Fehler das zwölfte Bit gestört wird, ergibt sich folgende Bitfolge:
gestörte Sequenz von Codewörtern:111, 10001, 111, 01011, 101

Die Decodierung von fünf Werten von vorn ergibt 111, 10001, 111, 0, 101, d. h. 1, -3, 1, 0, -1.

Die Decodierung von hinten ergibt jedoch folgende Sequenz:
101, 11010,
d. h. lediglich -1 sowie ein ungültiges Codewort. Aus diesem einfachen Beispiel ist zu sehen, daß durch die Decodierung von hinten, d. h. durch die Rückwärtsdecodierung, das ungültige Codewort 01011 sehr schnell erkannt wird. Ferner kann der Fehler durch den erfolgten Abbruch des Decodiervorgangs nach dem ungültigen Codewort sehr schnell eingegrenzt und identifiziert werden. Die Rückwärtsdecodierung meldet also einen Fehler im Bereich vom letzten Bit bis zum achten Bit von hinten.

Die zwei decodierten Zahlenreihen lauten folgendermaßen. Ein Fettdruck in der nachfolgenden Tabelle bedeutet, daß die Werte fehlerhaft sein können:

| | | | | | |
|---|---|---|---|---|---|
| vorwärts | 1 | -3 | 1 | 0 | -1 |
| rückwärts | x | x | x | x | -1 |

Inwieweit hier eine Fehlereingrenzung möglich ist, hängt von der Art des Fehlers ab und von der implementierten Fehlerverschleierungstechnik. Bekannte Fehlerverschleierungstechniken bestehen im einfachen Ersetzen eines fehlerhaften Werts durch seinen benachbarten intakten Wert. Andererseits können, wenn beide intakten Werte, die an einen Fehler angrenzen, bekannt sind, gewichtete Mittelwerte aus linkem und rechtem Rand verwendet werden, um den fehlerhaften Wert künstlich zu ersetzen, d. h. zu verschleiern. Wieder andere Fehlerverschleierungstechniken verwenden eine Interpolation unter Verwendung zweier benachbarter Werte, zwischen denen ein Fehler liegt. Genauso kann eine einseitige Prädiktion von vorne oder von hinten genommen werden, um einen fehlerhaften Wert durch einen "möglicherweise relativ intakten" Wert zu ersetzen.

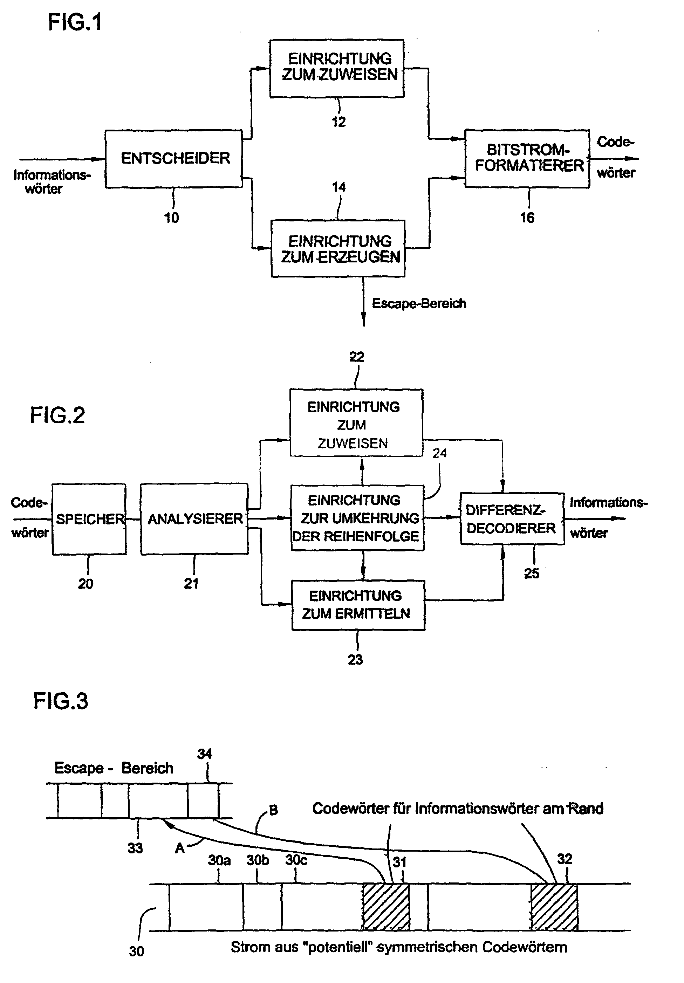

Fig. 1 zeigt einen Entropie-Codierer gemäß einem bevorzugten Ausführungsbeispiel der Erfindung. In einen Entscheider 10 werden zu codierende Informationswörter eingespeist. In den vorstehenden Tabellen bestanden Informationswörter der Einfachheit halber lediglich aus ganzen Zahlen. Bei einem Audiocodierer werden Informationswörter, die Entropie-codiert werden sollen, wie z. B. Skalenfaktoren, beispielsweise als Acht-Bit-Werte vorliegen. Der Ausdruck "Informationswörter" soll somit jede Darstellungsart umfassen, durch die eine zu codierende Information dargestellt werden kann.

In dem Entscheider 10 wird bestimmt, ob das Informationswort in einem Bereich von Informationswörtern oder außerhalb des Bereichs von Informationswörtern liegt. Der Bereich wird durch die in dem Codierer implementierte Codetabelle bestimmt. Wird in dem Entscheider bestimmt, daß ein zu codierendes Informationswort innerhalb des Bereichs liegt, wird dasselbe zu einer Einrichtung 12 zum Zuweisen eines symmetrischen Codeworts aus einer Gruppe von symmetrischen Codewörtern, d. h. aus der Codetabelle, übermittelt, derart, daß dem Informationswort ein symmetrisches Codewort zugewiesen wird. Entscheidet der Entscheider 10 andererseits, daß das Informationswort außerhalb des durch die Codetabelle bestimmten Bereichs liegt, wird dieses Informationswort vom Entscheider 10 zu einer Einrichtung 14 zum Erzeugen eines zusätzlichen Werts übermittelt, derart, daß die Einrichtung 14 bei einem bevorzugten Ausführungsbeispiel der vorliegenden Erfindung den Escape-Wert ermittelt. Die Einrichtung 14 umfaßt prinzipiell zwei Ausgänge, d. h. einen Ausgang zum Schreiben des Escape-Werts in einen Escape-Bereich des Bitstroms, und andererseits einen Ausgang, der mit einem Bitstromformatierer 16 verbunden ist, der einen Strom von Codewörtern bzw. eine Sequenz von Codewörtern erzeugt, die der am Eingang des Entscheiders 10 eingespeisten Sequenz von Informationswörtern zugeordnet ist.

Zur detaillierteren Erläuterung der Funktionsweise der Einrichtung zum Erzeugen eines zusätzlichen Werts oder Escape-Werts, die in Fig. 1 durch das Bezugszeichen 14 gekennzeichnet ist, sei auf Fig. 3 eingegangen. Fig. 3 zeigt einen fortlaufenden Strom 30 aus "potentiell" symmetrischen Codewörtern, wobei der Ausdruck "potentiell" andeuten soll, daß der Strom 30 bereits über einen nicht-idealen Kanal, z. B. eine Funkstrecke, übertragen worden ist, wodurch Bitstörungen aufgetreten sein können. Der Strom besteht aus einzelnen symmetrischen Codewörtern 30a, 30b, 30c, usw., die alle innerhalb des durch die Codetabelle, die symmetrische Codewörter umfaßt, festgelegten Bereichs liegen. Der Strom aus potentiell symmetrischen Codewörtern umfaßt jedoch ferner symmetrische Codewörter 31, 32, die für Informationswörter am Rand des Bereichs stehen. Die Codewörter 30a - 30c werden von der Einrichtung 12 zum Zuweisen erzeugt und in den Bitstromformatierer 16 eingespeist. Die Codewörter, die für Informationswörter am Rand des Bereichs bestehen, werden bei einem bevorzugten Ausführungsbeispiel der vorliegenden Erfindung durch die Einrichtung 14 erzeugt und von dort in den Bitstromformatierer 16 eingespeist, der den in Fig. 3 dargestellten Strom 30 bildet. Die Codewörter 30a - 30c und 31 und 32 stellen Informationswörter von -7 bis +7 dar, d. h. Informationswörter, denen symmetrische Codewörter zugeordnet sind. Hat das zu codierende Informationswort einen Wert von beispielsweise +12, so ergibt die Summe aus dem symmetrischen Codewort 31 und dem Escape-Wert den Wert +12.

Ein Decodierer, der auf das Codewort 31 stößt, erkennt sofort, daß es sich hier um ein Codewort am Rand des Bereichs handelt, weshalb der Decodierer zur Decodierung des Informationswortes mittels der Verknüpfung A in den Escape-Bereich "geht", um dort festzustellen, daß ein Escape-Wert von im vorliegenden Beispiel 5 vorhanden ist. Die Einrichtung 14 zum Erzeugen führt gemäß einem bevorzugten Ausführungsbeispiel der vorliegenden Erfindung somit zwei Funktionen durch. Zum einen liefert sie das Codewort für den Rand des Bereichs in den Strom 30 aus symmetrischen Codewörtern. Zum anderen bildet sie die Differenz zwischen dem zu codierenden Informationswort und dem Codewort am Rand des Bereichs und erzeugt einen Escape-Wert, der die Differenz darstellt. Selbstverständlich kann der Escape-Wert wiederum mittels des erfindungsgemäßen Codierverfahren Entropie-codiert werden. Es wird jedoch aus Datenkompressionsgründen bevorzugt, den Escape-Wert mittels eines Huffmancodes zu codieren. Aus Fig. 3 ist ferner ersichtlich, daß der Escape-Wert nicht in den Strom aus symmetrischen Codewörtern geschrieben wird, sondern an eine andere Stelle im Bitstrom.

Soll nun der Wert -12 codiert werden, so wird der Entscheider 10 feststellen, daß dieser Wert außerhalb des durch die Codetabelle mit symmetrischen Codewörtern definierten Bereichs liegt. Die Einrichtung 14 zum Erzeugen eines zusätzlichen Werts wird daher einerseits das Codewort für den Wert -7 an den Bitstromformatierer 16 ausgeben und zum anderen die Differenz, d. h. 5, in den Escape-Bereich schreiben. Der Wert -12 ergibt sich dann durch die Kombination des Werts -7, in Fig. 3 beispielsweise das Codewort 32, und des Escape-Werts 34 über die durch den Pfeil B dargestellte Verknüpfung.

Ein Wert von +7 würde bei dem bevorzugten Ausführungsbeispiel der vorliegenden Erfindung als Codewort für +7, d. h. als das Codewort 31, und 0 im Escape-Bereich, d. h. als der Escape-Wert 33, codiert werden.

In Abweichung vom beschriebenen Ausführungsbeispiel ist es nicht zwingend, daß die Einrichtung 14 zum Erzeugen eines zusätzlichen Werts die Differenz aus zu codierendem Informationswort und dem Informationswort am Rand des Bereichs bildet und einerseits ein symmetrisches Codewort in den Strom 30 aus symmetrischen Codewörtern schreibt und andererseits die Differenz in den Escape-Bereich schreibt. Es ist alternativ auch möglich, daß das gesamte Informationswort in den Escape-Bereich geschrieben wird, und im Strom aus symmetrischen Codewörtern lediglich ein Platzhalter, eine bestimmte Bitkombination oder ähnliches entweder durch die Einrichtung 14 oder auch durch den Bitstromformatierer 16 eingefügt wird, um einem nachgeschalteten Decodierer zu signalisieren, daß er an dieser Stelle im Bitstrom in den Escape-Bereich gehen muß. Das dargestellte Verfahren hat jedoch den Vorteil, daß zumindest der Teil des Informationsworts, der in dem Bereich liegt, der durch symmetrische Codewörter abgedeckt wird, mittels eines symmetrischen Codeworts codiert wird, wodurch nur die Differenz, die beispielsweise mittels eines Huffman-Codes codiert ist, weniger stark gesichert oder fehlerrobust ist. Das Alternativverfahren hätte dagegen den Vorteil, daß keine Addition bzw. Differenzbildung durchgeführt werden muß, und daß für ein Informationswort außerhalb des Bereichs der weniger redundante Code verwendet wird. Nachteilig ist jedoch, daß dann das außerhalb des Bereichs liegende Informationswort nicht rückwärts decodiert werden kann. Es können jedoch entweder im Stand der Technik bekannte Verfahren oder das erfindungsgemäße Codierverfahren zum Schutz des Escape-Bereichs eingesetzt werden, um auch hier sichere Verhältnisse zu schaffen.

Fig. 2 zeigt ein bevorzugtes Ausführungsbeispiel eines Decodierers gemäß der vorliegenden Erfindung. Eine Sequenz aus Codewörtern bzw. ein Strom aus "potentiell symmetrischen Codewörtern" 30 wird in einen Speicher 20 eingespeist, auf den ein Analysierer 21 zugreifen kann, um eine in dem Speicher 20 gespeicherte Sequenz zu analysieren. Der Analysierer 21 umfaßt zum einen eine Einrichtung zum Erfassen eines symmetrischen Codeworts aus der Sequenz 30 von Codewörtern und andererseits eine Einrichtung zum Erfassen eines vorbestimmten Codes in der Sequenz 30 von Codewörtern. Erfaßt der Analysierer 21 ein intaktes symmetrisches Codewort, so übermittelt er dieses zu einer Einrichtung 22 zum Zuweisen eines bestimmten Informationsworts zu dem Codewort basierend auf einer vorbekannten Codetabelle, die der im Codierer (Fig. 1) verwendeten Codetabelle entsprechen muß. Erfaßt der Analysierer 21 jedoch einen vorbestimmten Code, der im vorliegenden Beispiel das Codewort für einen Rand des Bereichs ist, so gibt er dieses Codewort zu einer Einrichtung 23 zum Ermitteln eines zusätzlichen Informationsworts außerhalb des Bereichs. Die Einrichtung 23 wird bei dem bevorzugten Ausführungsbeispiel beim Auftreten eines Codeworts 31 im Strom 30 auf den Escape-Bereich zugreifen und dort den entsprechenden Escape-Wert abrufen und zu dem Informationswort, das dem Codewort 31 entspricht, hinzuaddieren bzw. subtrahieren.

Die Zuweisung eines vorbestimmten Codes, im Ausführungsbeispiel des Codeworts für ein Informationswort am Rand, zu einem Codewort im Escapebereich kann auf verschiedene Arten und Weisen geschehen. Am einfachsten ist die Verwendung eines fortlaufenden Zeigers, wobei sowohl der Escape-Bereich als auch der Strom 30 synchronisiert sind. Diese Synchronisation wird bei dem bevorzugten Ausführungsbeispiel der vorliegenden Erfindung, bei dem Skalenfaktoren Entropie-codiert werden, dadurch gegeben, daß immer ein Block oder Frame eines Audiosignals verarbeitet wird. Für jeden Block wird der Escape-Bereich und der Strom 30 aus symmetrischen Codewörtern initialisiert, damit die Verwendung eines fortlaufenden Zeigers korrekte Ergebnisse liefert.

Der erfindungsgemäße Codierer umfaßt ferner eine Einrichtung 24 zur Umkehrung der Reihenfolge des Decodierers, die durch den Analysierer 21 aktiviert wird. Findet der Analysierer 21 in dem Strom 30 ein unsymmetrisches Codewort, so wird er die Einrichtung 24 zur Umkehrung der Reihenfolge aktivieren, da ein unsymmetrisches Codewort in dem Strom 30 aus potentiell symmetrischen Codewörtern nicht auftreten kann. Die Einrichtung 22 zum Zuweisen und die Einrichtung 23 zum Ermitteln arbeiten dann in der umgekehrten Reihenfolge vom anderen Ende der Sequenz aus Codewörtern, um mit einer Decodierung von hinten den Fehler einzugrenzen, derart, daß nur möglichst wenig Werte durch eine Fehlerverschleierung ersetzt werden müssen.

In der Realität kann es vorkommen, daß ein Entropie-Decodierer ein gestörtes Codewort nicht sofort erkennt, da die Störung nicht zu einem ungültigen Codewort geführt hat. Er decodiert also über den Fehler hinaus, bis er durch einen Folgefehler auf ein ungültiges Codewort stößt und die Codierung dann abbricht. Der Rückwärtsdecodierer decodiert dann vom anderen Ende aus unter Umständen ebenfalls über das gestörte Codewort hinweg und bricht irgendwann bei einem ungültigen Codewort ab. Damit ist ein Überlappungsbereich entstanden, in dem sowohl der Entropie-Vorwärts- als auch der Entropie-Rückwärtsdecodierer Ausgangswerte geliefert haben. Damit ist der Fehler auf den Überlappungsbereich eingegrenzt, und es kann festgestellt werden, daß die decodierten Werte außerhalb des Überlappungsbereichs korrekt sind.

Wenn im Codierer eine Differenzcodierung durchgeführt worden ist, so umfaßt der entsprechende Decodierer ferner einen Differenz-Decodierer 25, der die im Codierer erzeugte Differenzcodierung wieder rückgängig macht. Der Differenz-Decodierer 25 wird erfindungsgemäß durch die Einrichtung zur Umkehrung der Reihenfolge 24 ebenfalls aktiviert, um eine Rückwärts-Differenzdecodierung durchzuführen, um aus Differenz-codierten Informationswörtern, die der Einrichtung 25 von den Einrichtungen 22 und 23 übermittelt werden, auch in Rückwärtsrichtung wieder vollständig decodierte Informationswörter herzustellen. Es sei darauf hingewiesen, daß der Rückwärts-Differenzdecodierer und der Vorwärts-Differenzdecodierer getrennte Einrichtungen sein können, oder daß dieselben durch eine einzige Einrichtung implementiert sind, wobei bei der Vorwärts-Differenzdecodierung eine Addition ausgeführt wird, während bei der Rückwärts-Differenzdecodierung eine Subtraktion ausgeführt wird.

Die Kombination einer Differenz-Codierung mit dem Codierverfahren gemäß der vorliegenden Erfindung ist besonders vorteilhaft, da erst durch eine Differenz-Codierung bei geeignet gewähltem Ausgangswert der Differenzbildung die absoluten Informationswörter, z. B. um einen zu Null symmetrischen Bereich, "verschoben" werden.

Damit jedoch eine Differenz-Decodierung 25 in Rückwärtsrichtung vom anderen Ende einer Informationswörtersequenz aus möglich ist, muß am Ende der Sequenz von Informationswörtern im Codierer ein zusätzlicher Wert hinzugefügt werden, derart, daß der Differenz-Decodierer weiß, von wo aus eine Differenz-Decodierung von hinten gestartet werden soll. Wenn bei der Differenz-Codierung ein festgelegter Startwert eingesetzt worden ist, so bietet sich als zusätzlicher Wert ein zusätzlicher Differenzwert am Ende der Folge von Differenzcodierten Informationswörtern an, der die Differenz von dem letzten Informationswort zum festgelegten oder vorbestimmten Startwert angibt. Die Differenz wird selbstverständlich ebenfalls Entropie-codiert und wird vorzugsweise mittels eines symmetrischen Informationsworts Entropie-codiert, derart, daß dieser Wert gut geschützt ist, um eine RückwärtsDecodierung zu erlauben. Wenn als Startwert für die Differenz-Codierung im Codierer das erste Informationswort einer Sequenz von Informationswörtern genommen wird, so bietet es sich an, als zusätzlichen Wert am Ende der Sequenz den Absolutwert des letzten Informationsworts hinzuzufügen. Dieser letzte Wert wird dann ziemlich sicher nicht in dem Bereich von Informationswörtern liegen, die mit symmetrischen Codewörtern codiert werden.

Wie es bereits erwähnt wurde, besteht eine bevorzugte Anwendung der vorliegenden Erfindung bei der Codierung von Skalenfaktoren, die bisher zuerst differentiell und dann Huffman-codiert wurden. Im Stand der Technik wird eine Huffman-Tabelle mit 121 Codewörtern verwendet, um Werte im Bereich von -60 bis +60 codieren zu können. Da die Anzahl der zu codierenden Skalenfaktoren im Vergleich zur Anzahl der Spektralwerte sehr klein ist, ein typischer Wert liegt bei 40, ist eine relativ "schnelle" Detektion von Fehlern unbedingt notwendig, derart, daß der Decodierer nach dem Decodieren weniger Werte abbricht, damit ein Fehler relativ gut eingegrenzt werden kann. Deshalb wird eine "kleine" Codetabelle verwendet, was bedeutet, daß die Anzahl der symmetrischen RVLC-Codewörter klein sein soll.

Je kleiner die Codetabelle bzw. das Codebuch ist, desto wahrscheinlicher ist eine frühzeitigere Erkennung von Fehlern. Daher läuft der Bereich für Informationswörter, die symmetrisch codiert werden, von -7 bis +7. Für Werte, die im Bereich von 7 bis 60 liegen, wird der Escape-Wert übertragen. Vorzugsweise wird derselbe Huffman-codiert. Die "Escape"-Tabelle besteht somit aus 54 Einträgen für Werte zwischen 0 und 53. Jedesmal, wenn der Empfänger somit eine -7 oder eine +7 decodiert, muß er den dazugehörigen Escape-Wert decodieren und addieren bzw. subtrahieren.

Statistisch gesehen deckt das Intervall -7 bis +7 98% der auftretenden Skalenfaktorwerte ab, derart, daß Escape-Werte nicht besonders häufig vorkommen. Sollten häufigere Escape-Werte auftreten, oder wird der Fehlersicherheit ein noch größeres Augenmerk zuteil, so können verschiedene bekannte Verfahren und auch das erfindungsgemäße Verfahren eingesetzt werden, um auch die Escape-Werte fehlerrobuster zu machen.

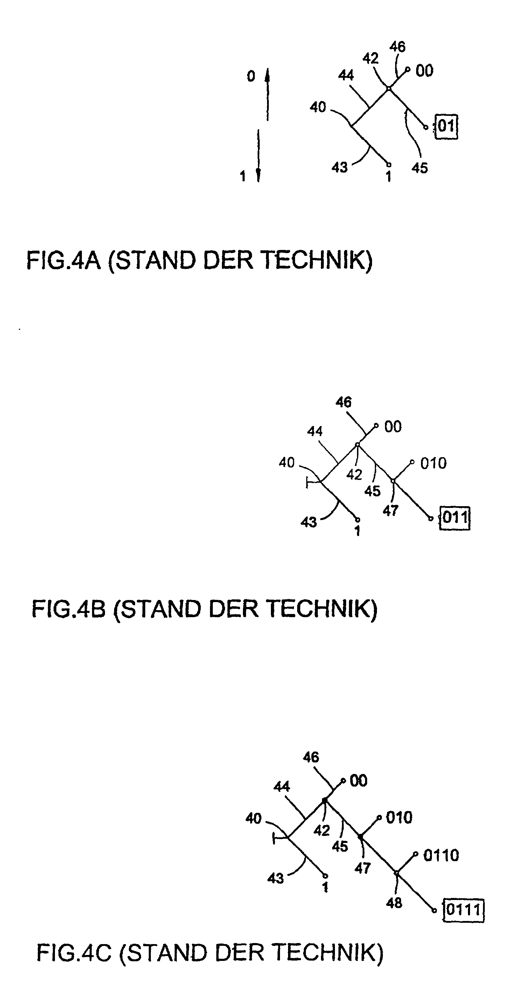

Zur Erläuterung des erfindungsgemäßen umkehrbaren Codes mit variabler Länge sei zunächst auf Fig. 4A eingegangen, in der ein bekannter symmetrischer Code gezeigt ist, der beispielsweise in der eingangs erwähnten Fachveröffentlichung von Göran Bang und Göran Roth offenbart ist. Dieser Code ist durch einen Codebaum definiert, der eine Wurzel 40 und einen Verzweigungspunkt 42 aufweist. An der Wurzel sind, da es sich um einen binären Code handelt, zwei Zweige 43, 44 angebracht, wobei der Zweig 43 die Wurzel 40 mit einem Endpunkt verbindet, der das gültige Codewort "1" definiert. Der Zweig 44 verbindet die Wurzel 40 mit dem Verzweigungspunkt 42, von dem zwei Zweige 45, 46 wegführen. Der Zweig 46 ist mit einem Endpunkt verbunden, der das zweite gültige Codewort dieses Codes "00" definiert, während der Zweig 45 ein ungültiges Codewort dieses Codes, d. h. "01", definiert. Das Codewort "01" ist deswegen ungültig, da es unsymmetrisch ist. Bezüglich der weiteren Notation sei darauf hingewiesen, daß in den Fig. 4A und 4C und in Fig. 5 ungültige Codewörter eingerahmt sind. Der in Fig. 4A gezeigte Code umfaßt somit lediglich zwei gültige Codewörter, d. h. "1" und "00", und nur ein einziges ungültiges Codewort, d. h. "01", das genauso lang wie das zweite gültige Codewort "00" ist.

Ein etwas längerer Code ist in Fig. 4B gezeigt. Im Gegensatz zu Fig. 4A enthält der Code in Fig. 4B ein weiteres gültiges Codewort "010" und ebenfalls ein ungültiges Codewort, das nun ebenfalls wie das zusätzliche gültige Codewort 3 Bit lang ist und den Wert "011" hat. Im Unterschied zu Fig. 4A ist der Zweig 45 nicht mit einem Endpunkt verbunden, sondern mit einem weiteren Verzweigungspunkt 47, von dem zwei Zweige ausgehen, wobei der erste ausgehende Zweig zum zusätzlichen gültigen Codewort "010" reicht, während der andere Zweig zum einzigen ungültigen Codewort "011" reicht.

Fig. 4C ist die logische Fortsetzung der Fig. 4A und 4B, da der Verzweigungspunkt 47 nun mit einem weiteren Verzweigungspunkt 48 verbunden ist, von dem wiederum zwei Zweige ausgehen, wobei ein Zweig ein zusätzliches symmetrisches Codewort "0110" definiert, während der Endpunkt des anderen Zweiges das einzige ungültige Codewort "0111" definiert, das die gleiche Länge (4 Bit) hat, wie das längste Codewort des Codebaums, d. h. der Codetabelle.

Aus Fig. 4C ist ferner zu sehen, daß keine gültigen Codewörter gleicher Länge existieren. Dies trifft ebenfalls auf die Codes in den Fig. 4A und 4B zu.

Die in den Fig. 4A bis 4C gezeigten Codes werden in der Fachveröffentlichung von Göran Bang und Göran Roth lediglich als Sicherheitsraster und nicht als Code zum Codieren von Informationen verwendet, da ein solcher Code, wie es ohne weiteres durch logische Fortsetzungen der in den Fig. gezeigten Codes ersichtlich ist, bei genügend hoher Anzahl von Codewörtern sehr lang wird. Außerdem ist die Fehlerrobustheit entsprechend längerer Codes sehr gering, da immer nur ein einziges ungültiges Codewort existiert und zudem dieses ungültige Codewort genauso lang wie das längste gültige Codewort ist. Ein Codieren von Informationen mit den bekannten Codes bietet sich daher nicht an, da die Codewörter sehr lang werden, wenn ein angemessener Bereich von Informationswerten codiert werden soll, und da immer nur ein ungültiges Codewort existiert, das darüberhinaus sehr lang ist. Ein Decodierer wird einen Fehler daher nicht sofort entdecken und eine große Anzahl von Folgefehlern begehen, bevor er auf ein ungültiges Codewort stößt und das Decodieren abbricht. Der Fehler wird also schlecht eingegrenzt.

Die in Fig. 5 gezeigte erfindungsgemäße Codetabelle überwindet diese Nachteile dadurch, daß im Codebaum wenigstens ein Verzweigungspunkt vorhanden ist, von dem zwei Zweige ausgehen, die beide mit einem Verzweigungspunkt statt mit einem Endpunkt verbunden sind. Bei dem in Fig. 5 gezeigten bevorzugten Ausführungsbeispiel für den umkehrbaren Code mit variabler Länge sind dies Verzweigungspunkte 50a, 50b, 50c und 50d. Der Codebaum in Fig. 5 umfaßt ferner eine Wurzel 52, von der zwei Zweige 53 und 54 ausgehen, wobei der Zweig 53 mit einem Endpunkt verbunden ist, durch den das erste und kürzeste Codewort 0 definiert ist, dem bei dem bevorzugten Ausführungsbeispiel der Informationswert "0" zugeordnet ist. Das Codewort 0 hat die kürzeste Länge und ist daher im Sinne einer Entropie-Codierung dem Informationswert zugeordnet, der am häufigsten auftritt. Bei dem bevorzugten Ausführungsbeispiel der vorliegenden Erfindung, bei dem die Informationswerte differenzcodiert sind, hat sich herausgestellt, daß insbesondere bei der Differenzcodierung von Skalenfaktoren der Wert 0 am wahrscheinlichsten auftritt.

Der andere Zweig, der von der Wurzel 52 ausgeht, d. h. der Zweig 54, endet erfindungsgemäß nicht in einem Codewort mit der Länge 2 Bit sondern führt zu dem Verzweigungspunkt 50a, der wiederum über zwei Zweige 55, 56 mit weiteren Verbindungspunkten 57, 58 verbunden ist. Die Verbindungspunkte 57 und 58 sind ihrerseits über entsprechende Zweige 59, 60 mit Endpunkten versehen, die die gültigen Codewörter 101 und 111 definieren. Im Gegensatz zum Stand der Technik ist hier zu sehen, daß durch Verzicht auf ein Codewort mit einer Länge von 2 Bit 2 Codewörter erhalten werden können, die gleich lang sind, d. h. 3 Bit in Fig. 5. Dieses sind die Codewörter 101 und 111. Sie sind bei der in Fig. 5 gezeigten Codetabelle den Informationswerten "-1" und "1" zugeordnet. Unter dem Gesichtspunkt der Entropiecodierung ist es günstig, für zwei Informationswerte, die sehr wahrscheinlich gleich häufig auftreten, auch gleich lange Codewörter vorzusehen.

Aus Fig. 5 ist zu sehen, daß von dem Verbindungspunkt 50c zwei Zweige 62, 63 ausgehen, wobei der Zweig 63 mit einem Verbindungspunkt 64 verbunden ist, der über Zweige mit einem gültigen Codewort 110011 und mit einem ungültigen Codewort 110010 verbunden ist. Trifft ein Decodierer nun beispielsweise auf das ungültige Codewort 110010, so wird er den Codiervorgang abbrechen, da ein solches Codewort nicht Umkehrbar ist und nie in einem Codierer erzeugt worden ist.

Das Zustandekommen und die Zuordnung weiterer Codewörter zu Informationswerten ist aus Fig. 5 ersichtlich. Es sei jedoch auf eine weitere Besonderheit hingewiesen. Eine bevorzugte Anwendung des in Fig. 5 gezeigten erfindungsgemäßen Codes besteht in der Verwendung des umkehrbaren Codes in Verbindung mit Escape-Werten. Wie es bereits dargestellt worden ist, wird ein Informationswert, der außerhalb des Bereichs von "-7" bis "+7" liegt, durch das Codewort für den entsprechenden Informationswert am Rand des Bereichs und die darüber hinausgehende Differenz in einer Escape-Tabelle codiert. Daher besteht eine höhere Wahrscheinlichkeit, daß im codierten Bitstrom der Wert am Rand des Bereichs, d. h. "-7" bzw. "7" codiert werden muß. Ferner ist die Wahrscheinlichkeit gleich groß, daß "-7" oder "+7" auftritt. Gemäß einem bevorzugten Ausführungsbeispiel der vorliegenden Erfindung werden die Informationswerte "-7" und "+7" durch Codewörter gleicher Länge, d. h. 1000001 bzw. 1100011, codiert, wobei diese Codewörter zugleich kürzer als die längsten auftretenden Codewörter sind, die in diesem Fall die Codewörter für "-6" und "+6" sind, um eine Codetabelle zu schaffen, die unter Entropiegesichtspunkten möglichst gut ist.

Aus Fig. 5 ist ferner zu sehen, daß acht ungültige Codewörter 66a - 66h existieren, während ein umkehrbarer Code gemäß dem Stand der Technik lediglich immer nur ein einziges ungüttiges Codewort hat bzw. haben kann. Eine große Anzahl von ungültigen Codewörtern und besonders relativ kurze ungültige Codewörter, wie z.B. die Codewörter 66e, 66f liefern eine hohe Fehlerrobustheit, derart, daß ein Decodierer möglichst schnell nach einem gestörten Informationswert die Decodierung abbricht, derart, daß ein Fehler möglichst eng eingegrenzt werden kann.

Schließlich sei zusammengefaßt, daß der in Fig. 5 dargestellte umkehrbare Code mit variabler Länge besonders gut für eine fehlerrobuste Entropie-Codierung von Informationswerten geeignet ist, da zum einen relativ viele relativ kurze ungültige Codewörter existieren, und da zum anderen für den Preis eines kürzeren Codewortes (im Beispiel das Codewort "11") zwei Codewörter (im Beispiel 101 und 111) erhalten werden, die zwar länger aber gleich wahrscheinlich sind. Obwohl der Verzicht eines gültigen kurzen Codeworts im Sinne der Entropie-Codierung eigentlich zu vermeiden ist, liefert derselbe erfindungsgemäß bei Anwendungen, bei denen eine fehlerrobuste Entropie-Codierung durchgeführt werden soll, und bei denen zusätzlich zwei Informationswerte mit relativ hoher Wahrscheinlichkeit und besonders mit annähernd gleicher Wahrscheinlichkeit vorhanden auftreten, eine gute Lösung. Bezüglich der Codetabellendarstellung in Baumform ist dieser Verzicht dadurch bewerkstelligt, daß besondere Verzweigungspunkte existieren, von denen zwei Zweige ausgehen, die jedoch beide statt mit einem Endpunkt mit weiteren Verzweigungspunkten verbunden sind.

## Patentansprüche

1. Vorrichtung zum Entropie-Codieren von Informationswörtern, mit folgenden Merkmalen:
einer Einrichtung (12) zum Zuweisen eines umkehrbaren Codeworts aus einer Gruppe von umkehrbaren Codewörtern zu einem Informationswort, das innerhalb eines Bereichs von Informationswörtern liegt, wobei die Gruppe von umkehrbaren Codewörtern derart ausgestaltet ist, daß für jedes Informationswort innerhalb des Bereichs ein eigenes umkehrbares Codewort vorgesehen ist;
einer Einrichtung (14) zum Erzeugen eines vorbestimmten umkehrbaren Codeworts (31, 32) für ein Informationswort, das außerhalb des Bereichs von Informationswörtern liegt, zum Erzeugen eines zusätzlichen Werts (33, 34) für das Informationswort, das außerhalb des Bereichs von Informationswörtern liegt, und zum Zuweisen eines nicht umkehrbaren Codeworts variabler Länge aus einer Gruppe von nicht-umkehrbaren Codewörtern variabler Länge zu dem zusätzlichen Wert (33, 34), wobei ein Escape-Bereich erzeugt wird, der von dem Datenstrom aus umkehrbaren Codewörtern getrennt ist und aus nicht umkehrbaren Codewörtern variabler Länge besteht, und wobei immer ein Codewort des Escape-Bereichs einem der vorbestimmten Codewörter (31, 32) des Datenstroms aus umkehrbaren Codewörtern zugeordnet ist (A, B); und
einer Datenstromformatiereinrichtung (16), die mit der Einrichtung (12) zum Zuweisen und der Einrichtung (14) zum Erzeugen verbunden und angeordnet ist, um einen Datenstrom aus umkehrbaren Codewörtern zu erzeugen, der lediglich umkehrbare Codewörter für Informationswörter innerhalb des Bereichs und vorbestimmte umkehrbare Codewörter für Informationswörter außerhalb des Bereichs umfaßt.

2. Vorrichtung nach Anspruch 1, bei der die umkehrbaren Codewörter symmetrische Codewörter sind.

3. Vorrichtung nach Anspruch 1 oder 2,
bei der die Einrichtung (14) zum Erzeugen derart angeordnet ist, daß sie ebenfalls für ein Informationswort, das auf einer Grenze des Bereichs von Informationswörtern liegt, einen zusätzlichen Wert erzeugt, und für das Informationswort, das auf der Grenze des Bereichs von Informationswörtern liegt, das vorbestimmte Codewort erzeugt.

4. Vorrichtung nach einem der vorhergehenden Ansprüche, die derart ausgestaltet ist, daß Informationswörter mit einer Auftrittswahrscheinlichkeit, die über einer vorbestimmten Grenzwahrscheinlichkeit liegt, in dem Bereich liegen.

5. Vorrichtung nach einem der vorhergehenden Ansprüche, bei der die Einrichtung (12) zum Zuweisen derart angeordnet ist, daß die Größe des Bereichs so gewählt ist, daß die Länge des längsten Codeworts der Gruppe von umkehrbaren Codewörtern kleiner oder gleich einer durch Fehlererkennungsgesichtspunkte festgelegten vorbestimmten Länge ist.

6. Vorrichtung nach einem der vorhergehenden Ansprüche, bei der die Einrichtung (14) zum Erzeugen derart angeordnet ist, daß sie als zusätzlichen Wert die Differenz zwischen dem Informationswort und dem Informationswort auf einer nächstliegenden Grenze des Bereichs bildet.

7. Vorrichtung nach einem der vorhergehenden Ansprüche,
bei der die Informationswörter jeweils Zahlenwerten von einer ersten zu einer zweiten Grenze und Zahlenwerten außerhalb der Grenzen entsprechen, wobei die erste und die zweite Grenze den Bereich von Informationswörtern definieren,
bei der die Einrichtung (12) zum Zuweisen angeordnet ist, um einem Informationswort, das auf einer Grenze oder außerhalb des Bereichs liegt, das vorbestimmte umkehrbare Codewort zuzuweisen, wobei das vorbestimmte umkehrbare Codewort dem umkehrbaren Codewort entspricht, das gemäß der Codetabelle für das Informationswort vorgesehen ist, das der Grenze des Bereichs entspricht, die anband ihres zahlenwerts dem Zahlenwert des informationsworts am nächsten liegt; und
bei der die Einrichtung (14) zum Erzeugen die Differenz zwischen dem zu codierenden Informationswort und dem Informationswort auf der Grenze des Bereichs als zusätzlichen Wert erzeugt, wobei das Vorzeichen der Differenz durch das Vorzeichen des Informationsworts auf der Grenze des Bereichs bestimmt ist, derart, daß das zu codierende Informationswort durch das vorbestimmte umkehrbare Codewort für das Informationswort auf der Grenze des Bereichs und eine vorzeichenlose Differenz als zusätzlicher Wert (33, 34) dargestellt wird.

8. Vorrichtung nach einem der vorhergebenden Ansprüche, die ferner folgendes Merkmal aufweist:
eine Einrichtung zum Differenz-Codieren von Informationen, die ausgehend von einem Startwert Differenz-codierte Informationswörter erzeugt, wobei aufeinanderfolgende Differenz-codierte Informationswörter eine Differenzwertsequenz darstellen.

9. Vorrichtung nach Anspruch 8, bei der die Einrichtung zum Differenz-Codieren ferner folgendes Merkmal aufweist:
eine Einrichtung zum Hinzufügen eines zusätzlichen Elements an das Ende der Differenzwertsequenz, wobei das zusätzliche Element derart bestimmt ist, daß eine Rückwärts-Decodierung der Differenzwertsequenz durchführbar ist.

10. Vorrichtung zum Decodieren von unter Verwendung von umkehrbaren Codewörtern Entropie-codierten Informationswörtern, die als ein Datenstrom und ein Escape-Bereich vorliegen, wobei der Datenstrom lediglich umkehrbare Codewörter für Informationswörter innerhalb eines Bereichs der Informationswörter aufweist, und wobei der Escape-Bereich nicht umkehrbare Codewörter für zusätzliche Werte, die Informationswörter außerhalb des Bereichs von Informationswörtern darstellen, aufweist, wobei immer ein Codewort des Escape-Bereichs einem vorbestimmten Codewort (31, 32) des Datenstroms zugeordnet ist (A, B), mit folgenden Merkmalen:
einer Einrichtung (21) zum Erfassen eines umkehrbaren Codeworts (30a, 30b, 30c) aus dem Datenstrom;
einer Einrichtung (22) zum Zuweisen eines bestimmten Informationsworts zu dem aus dem Datenstrom erfaßten Codewort, basierend auf einer Codetabelle;
einer Einrichtung (21) zum Erfassen eines vorbestimmten umkehrbaren Codeworts (31, 32) in dem Datenstrom;
einer Einrichtung (23) zum Ermitteln eines nicht umkehrbaren Codeworts variabler Länge in dem Escape-Bereich, das dem aus dem Datenstrom erfaßten vorbestimmten umkehrbaren Codewort zugeordnet ist, zum Zuweisen eines zusätzlichen Werts zu dem nicht umkehrbaren Codewort variabler Länge aufgrund einer Escape-Tabelle für die nicht umkehrbaren Codewörter variabler Länge, und zum Ermitteln eines Informationsworts außerhalb des Bereichs von Informationswörtern aufgrund des zusätzlichen Werts.

11. Vorrichtung nach Anspruch 10, bei der die nicht umkehrbaren Codewörter variabler Länge Huffman-Codewörter sind.

12. Vorrichtung nach einem der Ansprüche 10 oder 11, bei der die Einrichtung (21) zum Erfassen eines umkehrbaren Codeworts derart angeordnet ist, daß ein nicht-umkehrbares Codewort in dem ersten Datenstrom (30) feststellbar ist.

13. Vorrichtung nach Anspruch 12, die ferner folgendes Merkmal aufweist:
eine Einrichtung (24) zum Umkehren einer Reihenfolge, in der die Einrichtung (21) zum Erfassen die Codewortsequenz (30) bearbeitet, wobei die Einrichtung (24) zum Umkehren auf die Feststellung eines nicht-umkehrbaren Codeworts anspricht.

14. Vorrichtung nach einem der Ansprüche 10 bis 13, bei der die Informationswörter Differenz-codiert sind, die ferner folgendes Merkmal aufweist:
eine Einrichtung (25) zum Differenz-Decodieren der Differenz-codierten Informationswörter.

15. Vorrichtung nach Anspruch 13 oder 14, bei der die Sequenz von Informationswörtern ausgebend von einem Startwert Differenz-codiert ist, wobei die Sequenz ferner an ihrem anderen Ende einen zusätzlichen Wert hat, der derart gewählt ist, daß eine Rückwärts-Differenz-Decodierung von dem anderen Ende aus durchführbar ist, wobei die Einrichtung (25) zum Differenz-Decodieren angeordnet ist, um ansprechend auf die Einrichtung zum Umkehren der Reihenfolge eine Differenz-Decodierung von dem anderen Ende aus durchzuführen.

16. Vorrichtung nach einem der Ansprüche 10 bis 15, bei der das vorbestimmte umkehrbare Codewort (31, 32) das Codewort ist, das gemäß der Codetabelle einem Informationswort auf einer Grenze des Bereichs von Informationswörtern zugewiesen wird.

17. Vorrichtung nach Anspruch 16, bei der die Einrichtung (23) zum Ermitteln derart angeordnet ist, daß sie die Summe des Informationsworts auf einer Grenze des Bereichs und des zusätzlichen Werts bildet, um ein Informationswort zu erhalten, das außerhalb des Bereichs liegt.

18. Vorrichtung nach einem der vorhergehenden Ansprüche, bei der die Informationswörter Skalenfaktoren eines Transformations-codierten Audiosignals sind.

19. Verfahren zum Entropie-Codieren von Informationswörtern, mit folgenden Merkmalen:
Zuweisen (12) eines umkehrbaren Codeworts aus einer Gruppe von umkehrbaren Codewörtern zu einem Informationswort, das innerhalb eines Bereichs von Informationswörtern liegt, wobei die Gruppe von umkehrbaren Codewörtern derart ausgestaltet ist, daß für jedes Informationswort innerhalb des Bereichs ein eigenes umkehrbares Codewort vorgesehen ist;
Erzeugen (14) eines vorbestimmten umkehrbaren Codeworts (31, 32) für ein Informationswort, das außerhalb des Bereichs von Informationswörtern liegt,
Erzeugen (14) eines zusätzlichen. Werts (33, 34) für das Informationswort, das außerhalb des Bereichs von Informationswörtern liegt;
Erzeugen eines Datenstroms aus umkehrbaren Codewörtern, der lediglich umkehrbare Codewörter für Informationswörter innerhalb des Bereichs und vorbestimmte umkehrbare Codewörter für Informationswörter außerhalb des Bereichs umfaßt; und
Codieren des zusätzlichens Werts (33, 34) durch Zuweisen eines nicht umkehrbaren Codeworts variabler Länge aus einer Gruppe von nicht-umkehrbaren Codewörtern variabler Länge zu dem zusätzlichen Wert (33, 34), wobei ein Escape-Bereich erzeugh wird, der von dem Datenstrom aus umkehrbaren Codewörtern getrennt ist und aus nicht umkehrbaren Codewörtern variabler Länge besteht, und wobei immer ein Codewort des Escape-Bereichs einem der vorbestimmten Codewörter (31, 32) des Datenstroms zugeordnet ist (A, B).

20. Verfahren zum Decodieren von unter Verwendung von umkehrbaren Codewörtern Entropie-codierten Informationswörtern, die als ein Datenstrom und ein Escape-Bereich vorliegen, wobei der Datenstrom lediglich umkehrbare Codewörter für Informationswörter innerhalb eines Bereichs der Informationswörter aufweist, und wobei der Escape-Bereich nicht umkehrbare Codewörter für zusätzliche Werte, die Informationswörter außerhalb des Bereichs von Informationswörtern darstellen, aufweist, wobei immer ein Codewort des Escape-Bereichs einem vorbestimmten Codewort (31, 32) des Datenstroms zugeordnet ist (A, B), mit folgenden Schritten:
Erfassen (21) eines umkehrbaren Codeworts (30a, 30b, 30c) aus dem Datenstrom;
Zuweisen (22) eines bestimmten Informationsworts zu dem aus dem Datenstrom erfaßten Codewort, basierend auf einer Codetabelle;
Erfassen eines vorbestimmten umkehrbaren Codeworts (31, 32) in dem Datenstrom;
Ermitteln eines nicht umkehrbaren Codeworts variabler Länge in dem Escape-Bereich, das dem aus dem Datenstrom erfaßten vorbestimmten umkehrbaren Codewort zugeordnet ist;
Zuweisen eines zusätzlichen Werts zu dem nicht umkehrbaren Codewort variabler Länge aufgrund einer Escape-Tabelle für die nicht umkehrbaren Codewörter variabler Länge; und
Ermitteln (23) eines Informationsworts außerhalb des Bereichs von Informationswörtern aufgrund des zusätzlichen Werts.

## Claims

1. A device for entropy encoding of information words, comprising:
means (12) for assigning a reversible code word from a group of reversible code words to an information word which is located within a region of information words, the group of reversible code words being designed such that, for each information word within the region, there is provided one specific reversible code word each;
means (14) for producing a predetermined additional code word (31, 32) for an information word which is located outside the region of information words, for producing an additional value (33, 34) for the information word located outside the region of information words, and for assigning a non-reversible variable length code word from a group of non-reversible variable code words to said additional value (33, 34), with an escape region being produced that is separated from the data stream of reversible code words and consists of non-reversible variable length code words, there being always assigned one code word of the escape region to one of the predetermined code words (31, 32) of the data stream of reversible code words each (A, B); and
data stream formatting means (16) connected to the means (12) for assigning and to the means (14) for producing and being arranged to produce a data stream of reversible code words comprising only reversible code words for information words within said region and comprising predetermined reversible code words for information words outside said region.

2. A device according to claim 1, wherein the reversible code words are symmetrical code words.

3. A device according to claim 1 or 2,
wherein the means (14) for producing is arranged such that it produces an additional value also for an information word located on a boundary of said region of information words and such that it produces the predetermined code word for the information word located on the boundary of said region of information words.

4. A device according to any of the preceding claims, which is designed such that information words occurring with a probability of occurrence that is above a predetermined limit probability, are located in said region.

5. A device according to any of the preceding claims, wherein the means (12) for assigning is arranged such that the size of the region is selected so that the length of the longest code word of the group of reversible code words is smaller than or equal to a predetermined length defined by error recognition aspects.

6. A device according to any of the preceding claims, wherein the means (14) for producing is arranged so as to form as additional value the difference between the information word and the information word on a closest boundary of said region.

7. A device according to any of the preceding claims,
wherein the information words each correspond to numerical values from a first to a second boundary and numerical values outside the boundaries, said first and second boundaries defining said region of information words,
wherein the means (12) for assigning is arranged to assign to an information word located on a boundary or outside said region, the predetermined reversible code word, the predetermined reversible code word corresponding to the reversible code word provided according to the code table for the information word corresponding to the boundary of the region which, on the basis of its numerical value, is closest to the numerical value of the information word; and
wherein the means (14) for producing produces the difference between the information word to be coded and the information word on the boundary of the region as an additional value, the sign of the difference being determined by the sign of the information word on the boundary of the region, such that the information word to be coded is represented by the predetermined reversible code word for the information word on the boundary of the region and by a sign-free difference as additional value (33, 34).

8. A device according to any of the preceding claims, further comprising:
means for differential encoding of information which, on the basis of a starting value, produces differential-encoded information words, with successive differential-encoded information words representing a differential value sequence.

9. A device according to claim 8, wherein the means for differential encoding further comprises:
means for adding an additional element to the end of the differential value sequence, the additional element being defined such that backward decoding of the differential value sequence can be carried out.

10. A device for decoding of information words that are entropy-encoded using reversible code words, said information words being present in the form of a data stream and an escape region, the data stream comprising only reversible code words for information words with a region of information words and the escape region comprising non-reversible code words for additional values representing information words outside the region of information words, there being always assigned one code word of the escape region to one predetermined code word (31, 32) of the data stream each (A, B), said device comprising:
means (21) for detecting a reversible code word (30a, 30b, 30c) from the data stream;
means (22) for assigning a specific information word to the code word detected from the data stream, on the basis of a code table;
means (21) for detecting a predetermined reversible code word (31, 32) in the data stream;
means (23) for ascertaining a non-reversible variable length code word in the escape region, which is assigned to the predetermined reversible code word detected from the data stream, for assigning an additional value to the non-reversible variable length code word on the basis of an escape table for the non-reversible variable length code words, and for ascertaining an information word outside of the region of information words on the basis of the additional value.

11. A device according to claim 10, wherein the non-reversible variable length code words are Huffman code words.

12. A device according to any of claims 10 or 11, wherein the means (21) for detecting a reversible code word is arranged such that a non-reversible code word in the first data stream (30) can be ascertained.

13. A device according to claim 12, further comprising:
means (24) for reversing a sequence in which said means (21) for detecting processes the code word sequence (30), said means (24) for reversing being responsive to a non-reversible code word being ascertained.

14. A device according to any of claims 10 to 13, wherein the information words are differential-encoded and which further comprises:
means (25) for differential-decoding the differential-encoded information words.

15. A device according to claim 13 or 14, wherein the sequence of information words, starting from a starting value, is differential-encoded, the sequence furthermore having at the other end thereof an additional value which is selected such that backward differential decoding from the other end can be carried out, said means (25) for differential decoding being arranged to carry out differential decoding from the other end responsive to said means for reversing the sequence.

16. A device according to any of claims 10 to 15, wherein the predetermined reversible code word (31, 32) is the code word assigned according to the code table to an information word on a boundary of the region of information words.

17. A device according to claim 16, wherein the means (23) for ascertaining is arranged to form the sum of the information word on a boundary of the region and of the additional value, so as to obtain an information word located outside said region.

18. A device according to any of the preceding claims, wherein the information words are scale factors of a transformation-encoded audio signal.

19. A method for entropy encoding of information words, comprising:
assigning (12) a reversible code word from a group of reversible code words to an information word which is located within a region of information words, the group of reversible code words being designed such that, for each information word within the region, there is provided one specific reversible code word each;
producing (14) a predetermined reversible code word (31, 32) for an information word located outside said region of information words,
producing (14) an additional value (33, 34) for the information word which is located outside said region of information words;
producing a data stream of reversible code words comprising only reversible code words for information words within said region and comprising predetermined reversible code words for information words outside said region; and
coding the additional value (33, 34) by assigning a non-reversible variable length code word from a group of non-reversible variable length code words to the additional value (33, 34), with an escape region being produced which is separated from the data stream of reversible code words and consists of non-reversible variable length code words, there being always assigned one code word of the escape region to one of the predetermined code words (31, 32) of the data stream each (A, B).

20. A method for decoding of information words that are entropy-encoded using reversible code words, said information words being present in the form of a data stream and an escape region, the data stream comprising only reversible code words for information words within a region of information words and the escape region comprising non-reversible code words for additional values representing information words outside the region of information words, there being always assigned one code word of the escape region to one predetermined code word (31, 329 of the data stream each (A, B), said method comprising the following steps:
detecting (21) a reversible code word (30a, 30b, 30c) from the data stream;
assigning (22) a specific information word to the code word detected from the data stream, on the basis of a code table;
detecting (21) a predetermined reversible code word (31, 32) in the data stream;
ascertaining a non-reversible variable length code word in the escape region, which is assigned to the predetermined reversible code word detected from the data stream;
assigning an additional value to the non-reversible variable length code word on the basis of an escape table for the non-reversible variable length code words; and
ascertaining (23) an information word outside of the region of information words on the basis of the additional value.

## Revendications

1. Dispositif pour le codage entropique de mots d'informations, aux caractéristiques suivantes :
un dispositif (12) destiné à attribuer un mot de code inversible d'un groupe de mots de code inversibles à un mot d'information situé dans une plage de mots d'information, le groupe de mots de code inversibles se présentant de telle sorte qu'il est prévu, pour chaque mot d'information dans la plage, un mot de code inversible qui lui est propre ;
un dispositif (14) destiné à générer un mot de code inversible (31, 32) prédéterminé pour un mot d'information situé en dehors de la plage de mots d'information, à générer une valeur supplémentaire (33, 34) pour le mot d'information situé en dehors de la plage de mots d'information et à attribuer un mot de code non inversible de longueur variable d'un groupe de mots de code non inversibles de longueur variable à la valeur supplémentaire (33, 34), une zone d'échappement étant générée, laquelle est séparée du courant de données composé des mots de code inversibles et consiste en des mots de code non inversibles de longueur variable, et un mode de code de la zone d'échappement étant toujours associé à l'un des mots de code (31, 32) prédéterminés du courant de données composé des mots de code inversibles (A, B) ; et
un dispositif de formatage de courant de données (16) qui est relié au dispositif (12) d'attribution et au dispositif (14) de génération et disposé avec ces derniers, pour générer un courant de données composé de mots de code inversibles comprenant uniquement des mots de code inversibles pour les mots d'information dans la plage et des mots de code inversibles prédéterminés pour les mots d'information en dehors de la plage.

2. Dispositif selon la revendication 1, dans lequel les mots de code inversibles sont des mots de code symétriques.

3. Dispositif selon la revendication 1 ou 2, dans lequel le dispositif (14) de génération est disposé de telle sorte qu'il génère également, pour un mot d'information situé à la limite de la plage de mots d'information, une valeur supplémentaire et génère, pour le mot d'information situé à la limite de la plage de mots d'information, le mot de code prédéterminé.

4. Dispositif selon l'une des revendications précédentes, réalisé de telle sorte que les mots d'information se situent dans la plage avec une probabilité de production supérieure à une probabilité limite prédéterminée.

5. Dispositif selon l'une des revendications précédentes, dans lequel le dispositif (12) d'attribution est disposé de telle sorte que la grandeur de la plage est choisie de sorte que la longueur du mot de code le plus long du groupe de mots de codes inversibles est inférieure ou égale à une longueur prédéterminée établie de points de vue de reconnaissance d'erreurs.

6. Dispositif selon l'une des revendications précédentes, dans lequel le dispositif (14) de génération est disposé de telle sorte qu'il forme, comme valeur supplémentaire, la différence entre le mot d'information et le mot d'information à une limite la plus rapprochée de la plage.

7. Dispositif selon l'une des revendications précédentes, dans lequel les mots d'information correspondent, chacun, à des valeurs en nombre d'une première à une seconde limite et à des valeurs en nombre en dehors des limites, les première et seconde limites définissant la plage de mots d'information,
dans lequel le dispositif (12) d'attribution est disposé pour attribuer à un mot d'information situé sur une limite ou en dehors de la plage le mot de code inversible prédéterminé, le mode de code inversible prédéterminé correspondant au mot de code inversible prévu, selon le tableau de codes, pour le mot d'information correspondant à la limite de la plage se rapprochant le plus, sur base de sa valeur en nombre, de la valeur en nombre du mot d'information ; et
dans lequel le dispositif (149 de génération génère, comme valeur supplémentaire, la différence entre le mot d'information à coder et le mot d'information à la limite de la plage, le signe duquel est précédée la différence étant déterminé par le signe duquel est précédé le mot d'information à la limite de la plage, de sorte que le mot d'information à coder est représenté par le mot de code inversible prédéterminé pour le mot d'information à la limite de la plage et une différence précédée d'aucun signe, comme valeur supplémentaire (33, 34).

8. Dispositif selon l'une des revendications précédentes, présentant, par ailleurs, la caractéristique suivante :
un dispositif de codage par différence d'informations qui, partant d'une valeur de départ, génère des mots d'information codés par différence, des mots d'information codés par différence successifs représentant une séquence de valeurs différentielles.

9. Dispositif selon la revendication 8, dans lequel le dispositif de codage par différence présente, par ailleurs, la caractéristique suivante :
un dispositif destiné à insérer un élément supplémentaire à la fin de la séquence de valeurs différentielles, l'élément supplémentaire étant déterminé de telle sorte que puisse être effectué un décodage inversé de la séquence de valeurs différentielles.

10. Dispositif pour le décodage, à l'aide de mots de code inversibles, des mots d'information codés entropiquement présents sous forme de courant de données et d'une zone d'échappement, le courant de données présentant uniquement des mots de code inversibles pour des mots d'information dans une plage de mots d'information et la zone d'échappement présentant des mots de code non inversibles pour les valeurs supplémentaires représentant des mots d'information en dehors de la plage de mots d'information, un mot de code de la zone d'échappement étant toujours associé à un mode de code prédéterminé (31, 32) du courant de données (A, B), aux caractéristiques suivantes :
un dispositif (21) destiné à saisir un mot de code inversible (30a, 30b, 30c) du courant de données ;
un dispositif (22) destiné à attribuer un mot d'information déterminé au mot de code saisi du courant de données, sur base d'un tableau de codes ;
un dispositif (21) destiné à saisir un mot de code inversible prédéterminé (31, 32) dans le courant de données ;
un dispositif (23) destiné à déterminer un mot de code non inversible de longueur variable dans la zone d'échappement associé au mot de code inversible prédéterminé saisie du courant de données, à attribuer une valeur supplémentaire au mode de code non inversible de longueur variable sur base d'un tableau d'échappement pour les mots de code non inversibles de longueur variable, et à déterminer un mot d'information en dehors de la plage de mots d'informations sur base de la valeur supplémentaire.

11. Dispositif selon la revendication 10, dans lequel les mots de code non inversibles de longueur variable sont des mots de code de Huffman.

12. Dispositif selon l'une des revendications 10 ou 11, dans lequel le dispositif (21) de saisie d'un mot de code inversible est disposé de telle sorte qu'un mot de code non inversible peut être déterminé dans le premier courant de données (30).

13. Dispositif selon la revendication 12, présentant, par ailleurs, la caractéristique suivante :
un dispositif (24) destiné à inverser un ordre dans lequel le dispositif (21) de saisie traite la séquence de mots de code (30), le dispositif (24) d'inversion réagissant à la détection d'un mode de code non inversible.

14. Dispositif selon l'une des revendications 10 à 13, dans lequel les mots d'information sont codés par différence, présentant, par ailleurs, la caractéristique suivante
un dispositif (25) destiné à décoder par différence les mots d'information codés par différence.

15. Dispositif selon la revendication 13 ou 14, dans lequel la séquence de mots d'information est codée par différence en partant d'une valeur de départ, la séquence ayant, par ailleurs, à son autre extrémité, une valeur supplémentaire qui est choisie de sorte que puisse être effectué, depuis l'autre extrémité, un décodage par différence inverse, le dispositif (25) de décodage par différence étant disposé pour effectuer, en réaction au dispositif d'inversion de l'ordre, un décodage par différence depuis l'autre extrémité.

16. Dispositif selon l'une des revendications 10 à 15, dans lequel le mode de code inversible prédéterminé (31, 32) est le mot de code qui est attribué, selon le tableau de codes, à un mot d'information à une limite de la plage de mots d'informations.

17. Dispositif selon la revendication 16, dans lequel le dispositif (23) de détermination est disposé de telle sorte qu'il forme la somme des mots d'information à une limite de la plage et de la valeur supplémentaire, pour obtenir un mot d'information qui se situe en dehors de la plage.

18. Dispositif selon l'une des revendications précédentes, dans lequel les mots d'information sont des facteurs d'échelle d'un signal audio codé par transformation.

19. Procédé pour le codage entropique de mots d'informations, aux caractéristiques suivantes :
attribuer (12) un mot de code inversible d'un groupe de mots de code inversibles à un mot d'information situé dans une plage de mots d'information, le groupe de mots de code inversibles se présentant de telle sorte qu'il est prévu, pour chaque mot d'information dans la plage, un mot de code inversible qui lui est propre ;
générer (14) un mot de code inversible (31, 32) prédéterminé pour un mot d'information situé en dehors de la plage de mots d'information,
générer (14) une valeur supplémentaire (33, 34) pour le mot d'information situé en dehors de la plage de mots d'information ;
générer un courant de données composé de mots de code inversibles comprenant uniquement des mots de code inversibles pour les mots d'information dans la plage et des mots de code inversibles prédéterminés pour les mots d'information en dehors de la plage : et
coder la valeur supplémentaire (33, 34) en attribuant un mot de code non inversible de longueur variable d'un groupe de mots de code non inversibles de longueur variable à la valeur supplémentaire (33, 34), une zone d'échappement étant générée, laquelle est séparée du courant de données composé des mots de code inversibles et consiste en des mots de code non inversibles de longueur variable, et un mode de code de la zone d'échappement étant toujours associé à l'un des mots de code (31, 32) prédéterminés du courant de données (A, B).

20. Procédé pour le décodage, à l'aide de mots de code inversibles, des mots d'information codés entropiquement présents sous forme de courant de données et d'une zone d'échappement, le courant de données présentant uniquement des mots de code inversibles pour des mots d'information dans une plage de mots d'information et la zone d'échappement présentant des mots de code non inversibles pour les valeurs supplémentaires représentant des mots d'information en dehors de la plage de mots d'information, un mot de code de la zone d'échappement étant toujours associé à un mode de code prédéterminé (31, 32) du courant de données (A, B), aux caractéristiques suivantes :
saisir (21) un mot de code inversible (30a, 30b, 30c) du courant de données ;
attribuer (22) un mot d'information déterminé au mot de code saisi du courant de données, sur base d'un tableau de codes ;
saisir un mot de code inversible prédéterminé (31, 32) dans le courant de données ;
déterminer un mot de code non inversible de longueur variable dans la zone d'échappement associé au mot de code inversible prédéterminé saisi du courant de données,
attribuer une valeur supplémentaire au mode de code non inversible de longueur variable sur base d'un tableau d'échappement pour les mots de code non inversibles de longueur variable, et
déterminer (23) un mot d'information en dehors de la plage de mots d'informations sur base de la valeur supplémentaire.
